# EUROPEAN PATENT APPLICATION

(11) **EP 4 835 381 A1**
(43) Date of publication of application: **04.11.2026**
(21) Application number: 26743985.9
(22) Date of filing: 23.02.2026
(51) Int. Cl.: F25D 23/02, F25D 29/00, F25D 27/00, E05F 15/75, G06F 3/041

(54) **REFRIGERATOR**

(30) Priority: 24.02.2025 KR 20250023968
(71) Applicant: Samsung Electronics Co., Ltd, Suwon-si, Gyeonggi-do 16677 (KR)
(72) Inventor: LEE, Sangcheol, Suwon-si, Gyeonggi-do 16677 (KR); PARK, Taecheol, Suwon-si, Gyeonggi-do 16677 (KR); OH, Jonghak, Suwon-si, Gyeonggi-do 16677 (KR); GU, Yangyeol, Suwon-si, Gyeonggi-do 16677 (KR)
(74) Representative: Gulde & Partner
(86) International application number: PCT/KR2026/002963
(87) International publication number: WO 2026/177574

(57) **Abstract**

A refrigerator including a main body having a storage compartment, a door configured to open and close the storage compartment, a door opening device configured to open the door, and a touch-sensitive device configured to detect a touch for operating the door opening device. The touch-sensitive device includes a cover disposed on the door, an indicator exposed to the outside of the cover and configured to emit light, at least one light source disposed on an inner side of the cover, a printed circuit board on which the at least one light source is mounted, a light guide member configured to transmit light emitted from the at least one light source to the indicator, and a holder configured to cover the at least a portion of the light guide member to prevent light from leaking to a gap between the cover and the door and to support the printed circuit board.

## Description

### [Technical Field]

The present disclosure relates to a refrigerator.

### [Background Art]

A refrigerator is an apparatus keeping food fresh by including a main body having a storage space and a cold air supply device provided to supply cold air to the storage space, a door provided to open and close the storage space.

In order to enhance ease of use, a refrigerator may include a door opening device and a trigger provided to operate the door opening device. The door opening device may be provided to open a door when a user operates the trigger.

The trigger may be implemented in various ways, such as a button and a lever. For example, the trigger may include a touch sensor. In a case where the trigger includes a touch sensor, when the user touches the trigger provided with the touch sensor, the door opening device may open a door of a refrigerator.

When a refrigerator is placed in a dark environment or a light is not turned on at night, it may be difficult for the user to intuitively recognize the location of the trigger provided with the touch sensor.

### [Disclosure]

### [Technical Problem]

The present disclosure is directed to providing a refrigerator including a touch-sensitive device including an indicator provided to emit light and a door opening device configured to operate based on a touch to the indicator.

The present disclosure is directed to providing a touch-sensitive device including a light guide member configured to transmit light emitted from a light source to an indicator and a holder configured to cover at least a portion of the light guide member to prevent light passed through the light guide member from leaking, and a refrigerator including the same.

The present disclosure is directed to providing a touch-sensitive device in which a light guide member including an indicator and a holder configured to cover the light guide member to prevent light leakage are formed integrally to reduce production costs, and a refrigerator including the same.

Technical tasks to be achieved in this document are not limited to the technical task mentioned above, and other technical tasks not mentioned will be clearly understood by those skilled in the art from the description below.

### [Technical Solution]

A refrigerator according to an embodiment of the present disclosure may include a main body having a storage compartment, a door configured to open and close the storage compartment, a door opening device configured to open the door, and a touch-sensitive device configured to detect a touch for operating the door opening device. The touch-sensitive device may include a cover disposed on the door, an indicator exposed to the outside of the cover and configured to emit light, at least one light source disposed on an inner side of the cover, a printed circuit board on which the at least one light source is mounted, a light guide member configured to transmit light emitted from the at least one light source to the indicator, and a holder configured to cover the at least a portion of the light guide member to prevent light from leaking to a gap between the cover and the door and to support the printed circuit board.

### [Description of Drawings]

FIG. 1 illustrates a refrigerator according to an embodiment.
FIG. 2 illustrates a state in which a door of the refrigerator is opened according to an embodiment.
FIG. 3 is an enlarged view of area A in FIG. 1.
FIG. 4 shows FIG. 3 from a different angle.
FIG. 5 illustrates that a touch-sensitive device is separated from the door in the refrigerator according to an embodiment.
FIG. 6 is an exploded view of the touch-sensitive device in the refrigerator according to an embodiment.
FIG. 7 illustrates that a holder and a light guide member are separated in the refrigerator according to an embodiment.
FIG. 8 shows FIG. 7 from a different angle.
FIG. 9 illustrates a cross-section taken along line B-B' in FIG. 4.
FIG. 10 illustrates a cross-section taken along line C-C' in FIG. 5.

### [Modes of the Invention]

Various embodiments of the present disclosure and the terms used therein are not intended to limit the technical features described in the present disclosure to specific embodiments, and should be understood to include various modifications, equivalents, or substitutes of the embodiments.

In connection with the explanation of the drawings, like reference numbers may be used for like or related components.

The singular form of a noun corresponding to an item may include one item or a plurality of items, unless the relevant context clearly dictates otherwise.

In the present disclosure, each of phrases such as "A or B," "at least one of A and B," "at least one of A or B," "A, B or C," "at least one of A, B and C," and "at least one of A, B, or C" may include any one of the items listed together in the corresponding one of the phrases, or all possible combinations thereof.

The term "and/or" includes any combination of a plurality of related components or any one of a plurality of related components.

Terms such as "first," "second," "primary," and "secondary" may simply be used to distinguish a given component from other corresponding components, and do not limit the corresponding components in any other aspect (e.g., importance or order).

In the present disclosure, the terms "front surface," "rear surface," "upper surface," "lower surface," "side surface," "left side," "right side," "upper portion," and "lower portion" used in the following description are defined based on the drawings, and the shape and position of each component are not limited by these terms.

The terms "includes" and "has" are intended to indicate that there are features, numbers, steps, operations, components, parts, or combinations thereof described in the present disclosure, and do not exclude the presence or addition of one or more other features, numbers, steps, operations, components, parts, or combinations thereof.

When a certain component is referred to as being "connected to", "coupled to", "supported by" or "in contact with " another component, this includes a case in which the components are indirectly connected to, coupled to, supported by, or in contact with each other through a third component as well as directly connected to, coupled to, supported by, or in contact with each other.

When any component is referred to as being located "on" or "above" another component, this includes not only a case in which any component is in contact with another component but also a case in which another component is present between the two components.

A refrigerator according to an embodiment may include a main body.

The "main body" may include an inner case, an outer case disposed on the outside of the inner case, and an insulator provided between the inner case and the outer case.

The "inner case" may include at least one of a case, a plate, a panel and a liner forming a storage compartment. The inner case may be formed as a single body or may be formed by assembling a plurality of plates. The "outer case" may form an outer appearance of the main body and may be coupled to the outside of the inner case so that the insulator is disposed between the inner case and the outer case.

The "insulator" may insulate the inside and outside of the storage compartment so that a temperature inside the storage compartment may be maintained at a set appropriate temperature without being affected by an external environment of the storage compartment. According to an embodiment, the insulator may include a foam insulator such as polyurethane foam. A foam insulator may be formed by injecting and foaming urethane foam mixed with polyurethane and foaming agent between the inner case and the outer case.

According to an embodiment, the insulator may further include a vacuum insulator in addition to the foam insulator, or may be configured as only the vacuum insulator instead of the foam insulator. The vacuum insulator may include a core material and an outer shell material that accommodates the core material and seals the inside thereof with a vacuum or a pressure close to vacuum. However, the insulator is not limited to the foam insulator or vacuum insulator described above and may include various materials that may be used for insulation.

The "storage compartment" may include a space defined by the inner case. The storage compartment may further include an inner case defining a space corresponding to the storage compartment. The storage compartment may store various items such as food, medicine, and cosmetics, and may be formed such that at least one side thereof is open to allow items to be put in and to be taken out.

The refrigerator may include one or more storage compartments. When two or more storage compartments are formed in the refrigerator, the respective storage compartments may have different uses and may be maintained at different temperatures. To this end, the respective storage compartments may be partitioned from each other by partitions including the insulators.

The storage compartment may be provided to be maintained at an appropriate temperature range depending on the use, and may include a "refrigerating chamber," a "freezing chamber," or a "variable temperature chamber" depending on the use and/or temperature range. The refrigerating chamber may be maintained at an appropriate temperature for storing items in a refrigerated state, and the freezing chamber may be maintained at an appropriate temperature for storing items in a frozen state. "Refrigerating" may refer to cooling items to the point where the items are not frozen, and as an example, the refrigerating chamber may be maintained in a temperature ranging from zero degree Celsius to seven degrees Celsius. "Freezing" may refer to cooling items such that the items are freezing or maintained in a frozen state, as an example, the freezing chamber may be maintained at a temperature ranging from minus twenty degrees Celsius to minus one degree Celsius. The variable temperature chamber may be used as any one of the refrigerating chamber and the freezing chamber, depending on a selection of a user or regardless of the selection of the user.

In addition to names such as "refrigerating chamber," "freezing chamber," and "variable temperature chamber," the storage compartment may be referred to as various names such as "vegetable chamber," "fresh chamber," "cooling chamber," and "ice making chamber," terms such as "refrigerating chamber," "freezing chamber," and "variable temperature chamber" used below should be understood to encompass storage compartments with corresponding uses and temperature ranges, respectively.

According to an embodiment, the refrigerator may include at least one door configured to open and close the one open side of the storage compartment. The doors may each be provided to open and close the one or more storage compartments, or the one door may be provided to open and close a plurality of the storage compartments. The door may be rotatably or slidingly installed on a front side of the main body.

The "door" may be configured to seal the storage compartment when closed. Like the main body, the door may include the insulator to insulate the storage compartment when closed.

According to an embodiment, the door may include a door outer plate forming a front surface of the door, a door inner plate forming a rear surface of the door and facing the storage compartment, an upper cap, a lower cap, and a door insulator provided inside the upper and lower caps.

Edges of the door inner plate may be provided with a gasket sealing the storage compartment by coming into close contact with the front side of the main body when the door is closed. The door inner plate may include a dyke protruding rearward so that a door basket for storing items is mounted.

According to an embodiment, the door may include a door body, and a front panel detachably coupled to a front side of the door body and forming the front surface of the door. The door body may include the door outer plate forming a front surface of the door body, the door inner plate forming a rear surface of the door body and facing the storage compartment, the upper cap, the lower cap, and the door insulator provided inside the upper and lower caps.

Refrigerators may be classified into a French door type, a side-by-side type, a bottom mounted freezer (BMF) type, a top mounted freezer (TMF) type, and a one-door refrigerator type depending on the arrangement of doors and storage compartments.

According to an embodiment, the refrigerator may include a cold air supply device configured to supply cold air to the storage compartment.

The "cold air supply device" may include a machine, mechanism, electronic device, and/or a system combining them capable of generating cold air and guiding the cold air to cool the storage compartment.

According to an embodiment, the cold air supply device may generate cold air through a refrigeration cycle including compression, condensation, expansion, and evaporation processes of a refrigerant. To this end, the cold air supply device may include a refrigeration cycle device having a compressor, a condenser, an expansion device, and an evaporator capable of driving the refrigeration cycle. According to an embodiment, the cold air supply device may include a semiconductor such as a thermoelectric element. The thermoelectric element may cool the storage compartment by generating heat and cooling through the Peltier effect.

According to an embodiment, the refrigerator may include a machine room in which at least some components belonging to the cold air supply device are disposed.

The "machine room" may be provided to be partitioned and insulated from the storage compartment in order to prevent heat generated from the components disposed in the machine room from being transferred to the storage compartment. The inside of the machine room may be configured to communicate with the outside of the main body to dissipate heat from the components disposed inside the machine room.

According to an embodiment, the refrigerator may include a dispenser provided on the door to provide water and/or ice. The dispenser may be provided on the door such that the user may access the door without opening the door.

According to an embodiment, the refrigerator may include an ice making device provided to produce ice. The ice making device may include an ice making tray provided to store water, an ice moving device provided to separate the ice from the ice making tray, and an ice bucket provided to store the ice produced in the ice making tray.

According to an embodiment, the refrigerator may include a controller configured to control the refrigerator.

The "controller" may include memory provided to store or remember programs and/or data for controlling the refrigerator, and a processor provided to output a control signal for controlling the cold air supply device and the like according to the programs and/or data stored in the memory.

The memory stores or records a variety of information, data, commands, programs, and the like required for operations of the refrigerator. The memory may remember temporary data generated while generating control signals for controlling components included in the refrigerator. The memory may include at least one of volatile memory and non-volatile memory, or a combination thereof.

The processor controls the overall operation of the refrigerator. The processor may control the components of the refrigerator by executing the programs stored in the memory. The processor may include a separate NPU to perform operations of an artificial intelligence model. The processor may also include a central processor, a graphics processor (GPU), and the like. The processor may generate a control signal for controlling an operation of the cold air supply device. For example, the processor may receive temperature information of the storage compartment from a temperature sensor, and generate a cooling control signal for controlling the operation of the cold air supply device based on the temperature information of the storage compartment.

Additionally, the processor may process user input of a user interface according to the programs and/or data memorized/stored in the memory and control an operation of the user interface. The user interface may be provided using an input interface and an output interface. The processor may receive the user input from the user interface. The processor may also transmit a display control signal and image data for displaying an image on the user interface to the user interface in response to the user input.

The processor and the memory may be provided integrally or may be provided separately. The processor may include one or more processors. For example, the processor may include a main processor and at least one sub-processor. The memory may include one or more memories.

According to an embodiment, the refrigerator may include a processor and a memory to control all the components included in the refrigerator, and may include a plurality of processors and a plurality of memories to individually control the components of the refrigerator. For example, the refrigerator may include a processor and memory to control the operation of the cold air supply device depending on output of the temperature sensor. Also, the refrigerator may be separately equipped with a processor and memory to control the operation of the user interface according to user input.

A communication module may communicate with an external device such as a server, a mobile device, and another home appliance through a nearby access point (AP). The access point (AP) may connect a local area network (LAN) to which the refrigerator or a user device is connected to a wide area network (WAN) to which the server is connected. The refrigerator or the user device may be connected to the server via the wide area network (WAN).

The input interface may include a key, a touch screen, a microphone, and the like. The input interface may receive user input and transmit the user input to the processor.

The output interface may include a display, a speaker, and the like. The output interface may output various notifications, messages, a variety of information, and the like generated by the processor.

The terms "upward and downward directions," "forward and rearward directions," and the like used in the following description are defined based on the drawings, and a shape and position of each component are not limited by these terms. For example, the following terms "forward" and "rearward" may refer to a +X direction and -X direction indicated in the drawings, respectively. The following terms "upward" and "downward" may refer to a +Z direction and -Z direction indicated in the drawings, respectively. The following terms "left direction" and "right direction" may refer to a +Y direction and -Y direction indicated in the drawings, respectively. The following terms "vertical directions" may refer to the Z directions indicated in the drawings, respectively, and the following terms "horizontal directions" may refer to the Y directions indicated in the drawings, respectively. However, in some drawings, the +X direction may be referred to as "upward" and the -X direction may be referred to as "downward".

Hereinafter, embodiments according to the present disclosure will be described in detail with reference to the accompanying drawings.

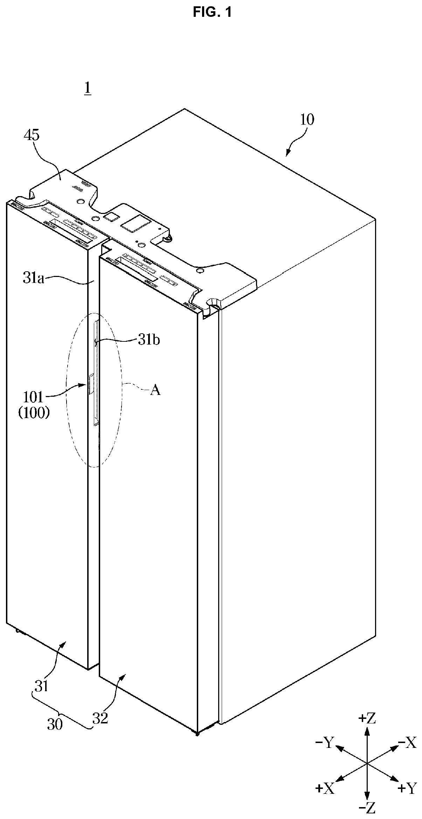

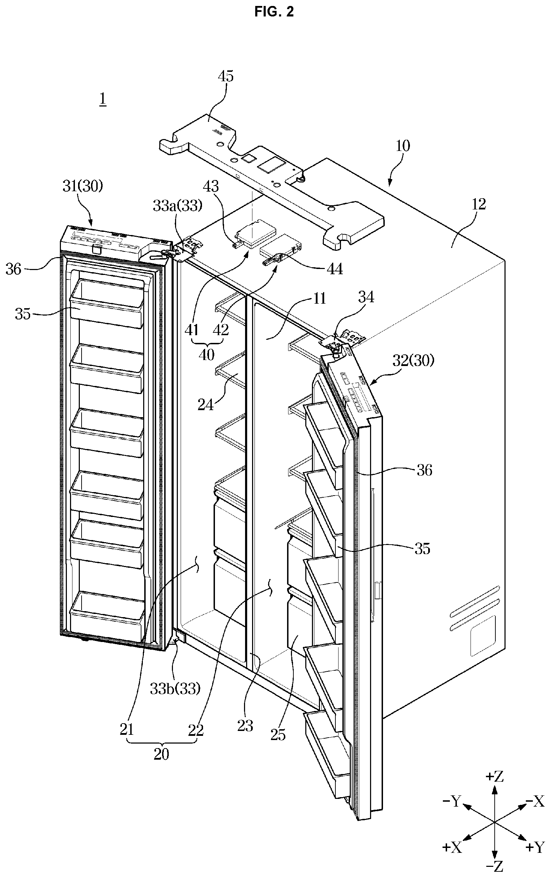

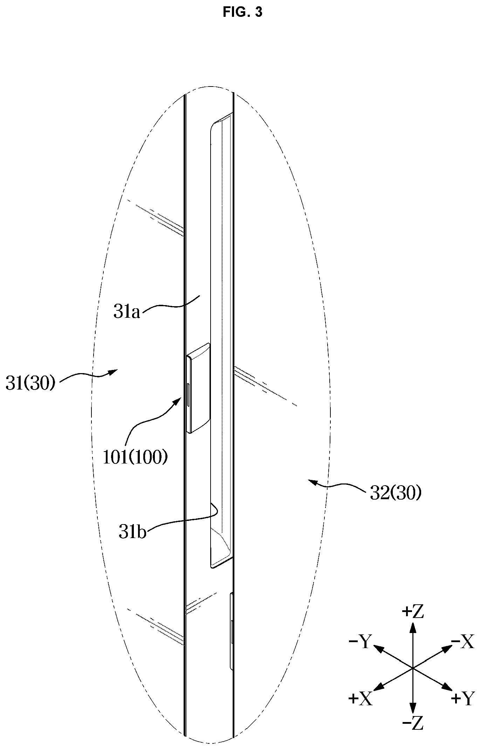

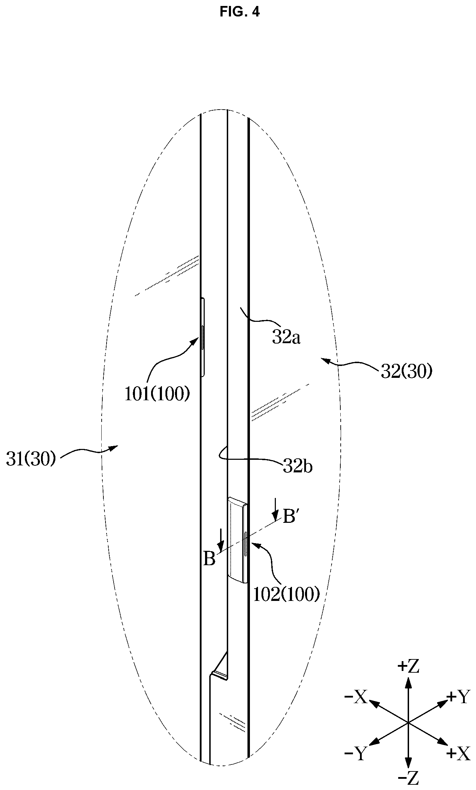

FIG. 1 illustrates a refrigerator according to an embodiment. FIG. 2 illustrates a state in which a door of the refrigerator is opened according to an embodiment. FIG. 3 is an enlarged view of area A in FIG. 1. FIG. 4 shows FIG. 3 from a different angle.

A refrigerator 1 according to an embodiment may include a main body 10 forming a storage compartment 20, a door 30 configured to open and close the storage compartment 20, and a cold air supply device configured to supply cold air to the storage compartment 20.

The main body 10 may include an inner case 11 forming the storage compartment 20, an outer case 12 provided on the outside of the inner case 11, and an insulator provided between the inner case 11 and the outer case 12.

The inner case 11 may be formed as a single body by molding a resin material such as acrylonitrile butadiene styrene copolymer (ABS), or may be formed by assembling a plurality of separate plates. The outer case 12 may form an outer appearance of the main body 10, and may be formed of a metal material such as iron plate or stainless steel in consideration of rigidity and the outer appearance.

Referring to FIGS. 1 and 2, the refrigerator 1 according to an embodiment may include a vertical partition wall 23 provided to partition the storage compartment 20. The storage compartment 20 may be partitioned into a first storage chamber 21 and a second storage chamber 22 by the vertical partition wall 23. The first storage chamber 21 and the second storage chamber 22 may be arranged left and right. The first storage chamber 21 may be used as any one of a refrigeration chamber and a freezing chamber, and the second storage chamber 22 may be used as the other one of the refrigeration chamber and the freezing chamber.

The division of the storage compartment 20 described above and the use of the divided storage compartment 20 are merely examples and are not limited thereto. For example, a refrigerator may include a horizontal partition wall, and a first storage chamber and a second storage chamber divided vertically by the horizontal partition wall. Also, a refrigerator may include both a vertical partition wall and a horizontal partition wall. For example, a refrigerator may include a first storage chamber positioned above a horizontal partition wall, a second storage chamber positioned below the horizontal partition wall, and the second storage chamber may be divided into a left storage chamber and a right storage chamber by a vertical partition wall. The divided storage chambers may be used as at least one of a refrigerating chamber and a freezing chamber.

The refrigerator 1 may include at least one shelf 24 provided inside the storage compartment 20. The at least one shelf 24 may be provided to support food or a storage container provided to accommodate food.

The refrigerator 1 may include at least one drawer 25 provided to be withdrawable from the storage compartment 20 and to accommodate food or a storage container therein.

The refrigerator 1 may include a door 30 configured to open and close the storage compartment 20. The door 30 may be rotatably coupled to the main body 10. The door 30 may open or close the storage compartment 20 by rotating relative to the main body 10.

According to an embodiment, the door 30 may include a first door 31 configured to open and close the first storage chamber 21, and a second door 32 configured to open and close the second storage chamber 22.

The refrigerator 1 may include hinges 33 and 34 provided to rotatably couple the door 30 to the main body 10. The hinges 33 and 34 may include the first hinge 33 configured to rotatably couple the first door 31 to the main body 10, and the second hinge 34 configured to rotatably couple the second door 32 to the main body 10, respectively.

The first hinge 33 may include a first upper hinge 33a provided on an upper portion of the main body 10 and coupled with an upper portion of the first door 31, and a first lower hinge 33b provided on a lower portion of the main body 10 and coupled with a lower portion of the first door 31. The second hinge 34 may include a second upper hinge 34a provided on the upper portion of the main body 10 and coupled with the upper portion of the second door 32, and a second lower hinge provided on the lower portion of the main body 10 and coupled with the lower portion of the second door 32.

The door 30 may include at least one door guard 35 provided to accommodate food or a storage container and provided on a rear surface of the door 30. A gasket 36 may be provided at an edge of the rear surface of the door 30 to prevent cold air inside the storage compartment 20 from leaking between the door 30 and the main body 10 when the door 30 closes the storage compartment 20.

The refrigerator 1 may include a cold air supply device configured to supply cold air to the storage compartment 20. According to an embodiment, the cold air supply device may include a compressor, a condenser, an expansion valve, and an evaporator to generate cold air through a refrigeration cycle. According to an embodiment, the cooling device may include a semiconductor, such as a thermoelectric element. The thermoelectric element may cool the storage compartment 20 by heat generation and cooling action through the Peltier effect.

The cold air supply device may include a cold air duct provided to guide cold air into the storage compartment 20, and a blowing fan configured to move cold air toward the storage compartment 20.

The refrigerator 1 may include a machine room formed inside the main body 10. The machine room may be configured to accommodate at least one component of the cold air supply device. For example, the machine room may be provided between the outer case 12 and the inner case 11, and may be provided at a lower rear side of the main body 10.

Referring to FIG. 2, the refrigerator 1 may include a door opening device 40 configured to open the door 30.

The door opening device 40 may be configured to push the rear surface of the door 30 forward. The door opening device 40 may include pushers 43 and 44 provided to be movable forward and rearward. At least portions of the pushers 43 and 44 may be withdrawn from the door opening device 40 by moving forward. The at least portions of the pushers 43 and 44 withdrawn from the door opening device 40 may be inserted into the door opening device 40 by moving rearward. The pushers 43 and 44 may push the rear surface of the door 30 by moving forward. The door 30 may be opened by the forward movement of the pushers 43 and 44.

As the door opening device 40 partially opens the door 30, a user may open the door 30 with a little force. The partially opening of the door 30 may refer to opening the door 30 to a rotation angle less than the maximum rotation angle of the door 30.

The door opening device 40 may include a first door opening device 41 configured to open the first door 31 by pushing, and a second door opening device 42 configured to open the second door 32 by pushing. Because the first door opening device 41 and the second door opening device 42 have substantially the same configuration, only the first door opening device 41 will be described below. Additionally, the first door opening device 41 will be referred to as the door opening device 40.

Referring to FIGS. 1 and 2, the refrigerator 1 may include a door opening device cover 45 provided to cover the door opening device 40 to prevent the door opening device 40 from being exposed to the outside. The door opening device cover 45 may be provided to be coupled to an upper surface of the main body 10. A space may be formed between the door opening device cover 45 and the upper surface of the main body 10, and the door opening device 40 may be accommodated in this space. According to an embodiment, a portion of the upper surface of the main body may be recessed downward to form an accommodation space. At least a portion of the door opening device may be accommodated in the accommodation space.

Referring to FIGS. 1 and 3, a first handle 31b may be formed on a side surface 31a of the first door 31. The first handle 31b may be formed by at least a portion of the side surface 31a of the first door 31 being recessed. The user may open and close the first door 31 by putting a hand thereof into the first handle 31b.

The first handle 31b may not be formed from an upper end to a lower end of the side surface 31b of the first door 31, but may be formed in a partial area between the upper end and the lower end of the side surface 31b of the first door 31. Accordingly, the remaining space, excluding the partial area occupied by the first handle 31b, may be utilized as a space inside the first door 31, and the internal space of the first door 31 may be increased.

A second handle 32b may be formed on a side surface 32a of the second door 32. The second handle 32b may be formed by at least a portion of the side surface 32a of the second door 32 being recessed. The user may open and close the second door 32 by putting the hand thereof into the second handle 32b.

The second handle 32b may not be formed from an upper end to a lower end of the side surface 32b of the second door 32, but may be formed in a partial area between the upper end and the lower end of the side surface 32b of the second door 32. Accordingly, the remaining space, excluding the partial area occupied by the second handle 32b, may be utilized as a space inside the first door 31, and the internal space of the second door 32 may be increased.

Referring to FIGS. 1, 3 and 4, the refrigerator 1 may include a touch-sensitive device 100. The user may operate the door opening device 40 by touching the touch-sensitive device 100. In other words, the door opening device 40 may be configured to be operated by the touch-sensitive device 100. The touch-sensitive device 100 may be manipulated by the touch of the user. The touch-sensitive device 100 may be configured to recognize the touch of the user.

The touch-sensitive device 100 may include a first touch-sensitive device 101 provided in the first door 31 and a second touch-sensitive device 102 provided in the second door 32.

The first touch-sensitive device 101 may detect the touch of the user. The first touch-sensitive device 101 may generate a touch signal in response to the touch of the user. A processor may receive the touch signal generated from the first touch-sensitive device 101. The processor may generate a control signal for operating the first door opening device 41 based on the touch signal. The first door opening device 41, which has received the control signal, may move the pusher 43 forward to open the first door 31.

The second touch-sensitive device 102 may detect the touch of the user. The second touch-sensitive device 102 may generate a touch signal in response to the touch of the user. The processor may receive the touch signal generated from the second touch-sensitive device 102. The processor may generate a control signal for operating the second door opening device 42 based on the touch signal. The second door opening device 42, which has received the control signal, may move the pusher 44 forward to open the second door 32.

The first touch-sensitive device 101 may be provided on the side surface 31a of the first door 31. The first touch-sensitive device 101 may be positioned in front (+X direction) of the first handle 31b formed on the side surface 31a of the first door 31. By the position of the first touch-sensitive device 101, the first touch-sensitive device 101 may be touched at the same time as the user holds the first handle 31b with the hand thereof. As described above, as the first touch-sensitive device 101 is touched by the user, the door opening device 40 may open the first door 31.

The first touch-sensitive device 101 may be configured such that a portion thereof emits light. Specifically, an indicator 131 of the first touch-sensitive device 101 may emit light. The user may easily and accurately recognize a touch position of the first touch-sensitive device 101 through the light emitted from the indicator 131. At least a portion of the first touch-sensitive device 101 may be provided to protrude from the side surface 31a of the first door 31.

Referring to FIG. 4, the second touch-sensitive device 102 may be provided on the side surface 32a of the second door 32. The second touch-sensitive device 102 may be positioned in front (+X direction) of the second handle 32b formed on the side surface 32a of the second door 32. By the position of the second touch-sensitive device 102, the second touch-sensitive device 102 may be touched at the same time as the user holds the second handle 32b with the hand thereof. As described above, as the second touch-sensitive device 102 is touched by the user, the door opening device 40 may open the second door 32.

The second touch-sensitive device 102 may be configured such that a portion thereof emits light. Specifically, an indicator of the second touch-sensitive device 102 may emit light. The user may easily and accurately recognize a touch position of the second touch-sensitive device 102 through the light emitted from the indicator. At least a portion of the second touch-sensitive device 102 may be provided to protrude from the side surface 32a of the second door 32.

According to an embodiment, heights of the first touch-sensitive device 101 and the second touch-sensitive device 102 may be different from each other. The height of the first touch-sensitive device 101 may refer to a vertical distance from the ground to the first touch-sensitive device 101. Similarly, the height of the second touch-sensitive device 102 may refer to a vertical distance from the ground to the second touch-sensitive device 102. The vertical distance may refer to a distance in a Y direction of the drawings.

As the height of the first touch-sensitive device 101 and the height of the second touch-sensitive device 102 are different, when the first touch-sensitive device 101 is touched, the second touch-sensitive device 102 may be prevented from being touched unintentionally. Similarly, when the second touch-sensitive device 102 is touched, the first touch-sensitive device 101 may be prevented from being touched unintentionally. Through these, malfunction of the door opening device 40 may be prevented.

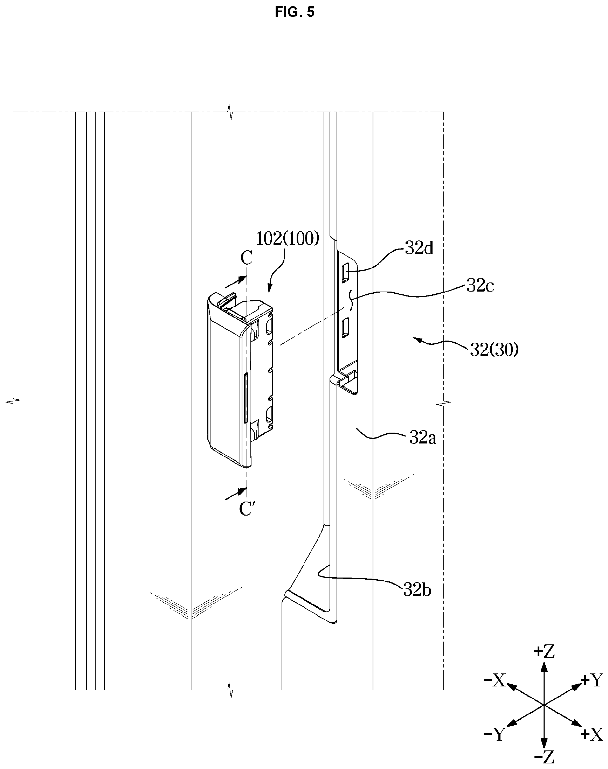

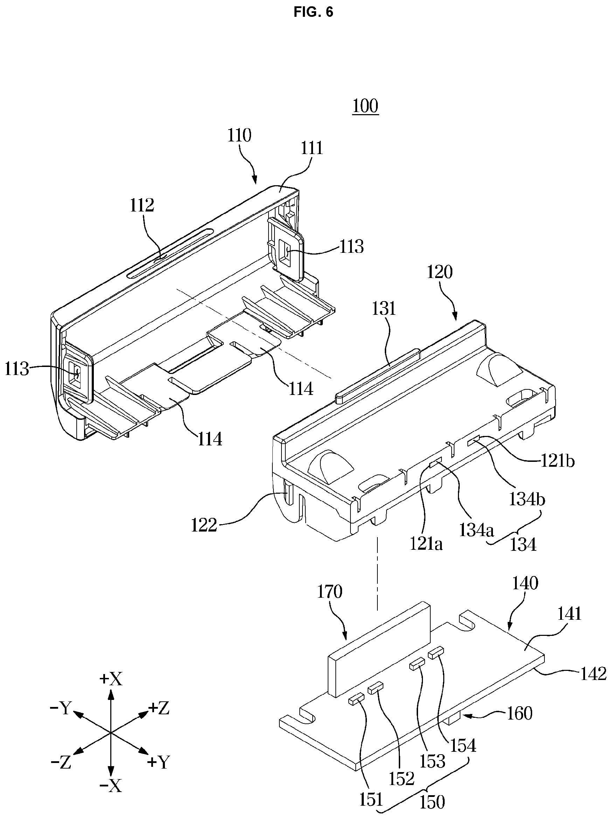

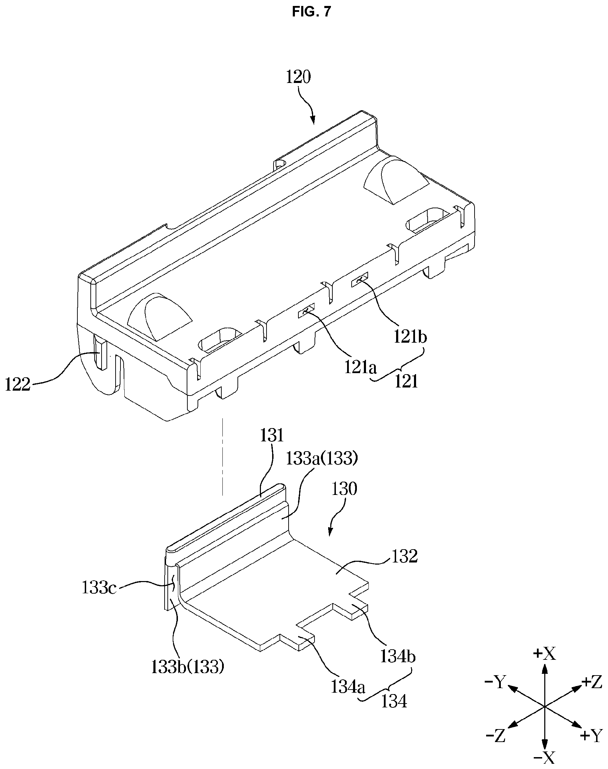

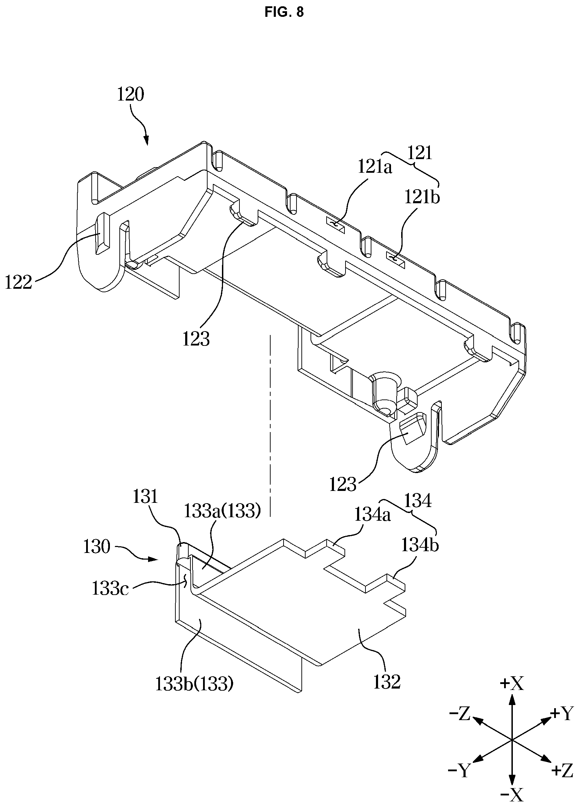

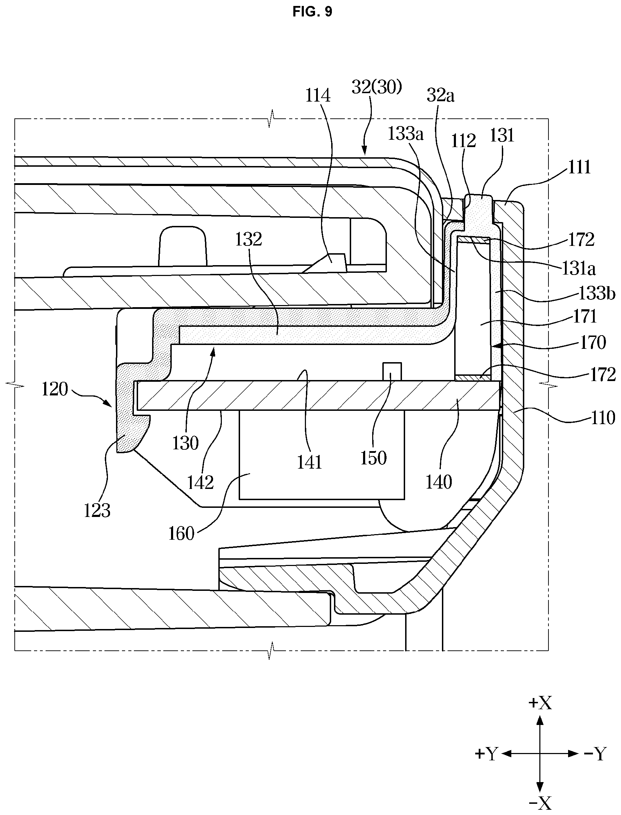

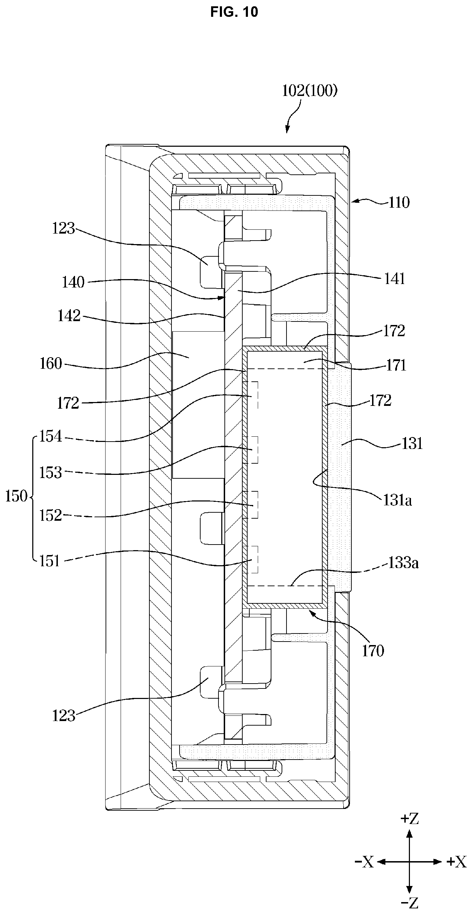

FIG. 5 illustrates that a touch-sensitive device is separated from the door in the refrigerator according to an embodiment. FIG. 6 is an exploded view of the touch-sensitive device in the refrigerator according to an embodiment. FIG. 7 illustrates that a holder and a light guide member are separated in the refrigerator according to an embodiment. FIG. 8 shows FIG. 7 from a different angle. FIG. 9 illustrates a cross-section taken along line B-B' in FIG. 4. FIG. 10 illustrates a cross-section taken along line C-C' in FIG. 5.

Hereinafter, a structure of the touch-sensitive device 100 according to an embodiment will be described with reference to FIGS. 5 to 8. Because the first touch-sensitive device 101 and the second touch-sensitive device 102 have substantially the same configuration, only the second touch-sensitive device 102 will be described. The second touch-sensitive device 102 will be referred to as the touch-sensitive device 100. Also, hereinafter, only the second door 32 will be described, but the following description may be equally applied to the first door 31.

Referring to FIGS. 5 to 8, the touch-sensitive device 100 may include a cover 110 forming an outer appearance of the touch-sensitive device 100, a light guide member 130 disposed on an inner side of the cover 110 and including the indicator 131, a holder 120 provided on the inner side of the cover 110 to cover at least a portion of the light guide member 130, a printed circuit board 140, at least one light source 150 configured to emit light, and a touch sensor 160.

The cover 110 may form the outer appearance of the touch-sensitive device 100 exposed to the outside of the second door 32 together with the indicator 131. At least a portion of the cover 110 may protrude from the side surface 32a of the second door 32.

A portion of the cover 110 protruding from the side surface 32a of the second door 32 and the remaining portion of the touch-sensitive device 100, excluding the indicator 131, may be disposed on the inside of the second door 32. In order to accommodate the touch-sensitive device 100, a door accommodation portion 32c may be provided on the side surface 32a of the second door 32. The door accommodation portion 32c may be formed by a portion of the side surface 32a of the second door 32 being recessed inward. In the door accommodation portion 32c, at least one door groove 32d provided such that a cover protrusion 114 of the touch-sensitive device 100 is inserted thereinto may be formed.

As described above, the touch-sensitive device 100 may be disposed in front of the second handle 32b. Therefore, the door accommodation portion 32c for accommodating the touch-sensitive device 100 may be positioned in front of the second handle 32b on the side surface 32a of the second door 32.

A portion of the cover 110 may be disposed to face the front of the refrigerator 1. Hereinafter, a portion of the cover 110 disposed to face the front (+X direction) of the refrigerator 1 will be referred to as a front surface 111 of the cover 110. A cover hole 112 into which the indicator 131 is inserted may be formed on the front surface 111 of the cover 110. The indicator 131 may be exposed to the outside of the cover 110 through the cover hole 112.

According to an embodiment, the indicator 131 may protrude forward from the front surface 111 of the cover 110 through the cover hole 112. In a case where a front surface of the indicator 131 protrudes forward more than the front surface 111 of the cover 110, the four side surfaces around the front surface of the indicator 131 may also be exposed to the outside of the cover 110. Accordingly, light emitted to the outside of the cover 110 through the indicator 131 may be emitted through the front surface of the indicator 131 and the four side surfaces surround thereof.

According to an embodiment, the indicator 131 may be inserted into the cover hole 112, and the front surface of the indicator 131 may be positioned on the same surface as the front surface 111 of the cover 110.

According to an embodiment, the indicator 131 may be inserted into the cover hole 112, and the front surface of the indicator 131 may be positioned behind the front surface111 of the cover 110. In other words, the indicator 131 may be positioned behind the front surface 111 of the cover 110 in a state of being inserted into the cover hole 112.

In this specification, the indicator may refer to a portion of the touch-sensitive device indicating a touch position to the user. For example, the indicator may refer to a portion emitting light to recognize a touch position. The indicator may be referred to as various terms such as a light emitting portion, an identification portion, and a display portion.

The indicator 131 exposed to the outside of the cover 110 may receive light emitted from the at least one light source 150 and emit the received light to the outside of the cover 110. The light emitted from the at least one light source 150 may be emitted to the outside of the touch-sensitive device 100 through the indicator 131. Accordingly, even when the refrigerator 1 is located in a dark place or a light is not turned on at night, the user may easily identify the indicator 131 and thus easily recognize a location of the touch-sensitive device 100.

A size and shape of the cover hole 112 formed on the front surface 111 of the cover 110 may be provided to correspond to a size and shape of the indicator 131. A width and length of the cover hole 112 may be provided to be substantially the same as a width and length of the indicator 131. However, because the indicator 131 needs to be inserted into the cover hole 112, the width and length of the cover hole 112 may be slightly larger than the width and length of the indicator 131. For example, as illustrated in FIG. 5, the cover hole 112 and the indicator 131 may be provided in shapes corresponding to each other, and may be a straight shape with a narrow width and a long vertical length. The shapes of cover hole 112 and indicator 131 are not limited thereto. For example, the cover hole 112 and the indicator 131 may be provided in various shapes such as an arc shape, a circle shape, a square shape, an S shape, a zigzag shape, a hidden line.

The touch-sensitive device 100 may include the light guide member 130 (FIG. 7) disposed on the inner side of the cover 110 and including the indicator 131. A portion of the light guide member 130 may be the indicator 131 described above. Because a portion of the light guide member 130 is the indicator 131, the light guide member 130 may include the indicator 131.

The indicator 131, which is a portion of the light guide member 130, may be exposed to the outside of the cover 110. The remaining portion of the light guide member 130, excluding the indicator 131, may be disposed on the inner side of the cover 110. The indicator 131 may refer to a portion of the light guide member 130 exposed to the outside of the cover 110 through the cover hole 112. The remaining portion of the light guide member 130, excluding the indicator 131, is covered by the cover 110 and therefore may not be exposed to the outside of the cover 110 and the second door 32.

According to an embodiment, the cover 110 may include a coupling hole 113 provided such that a coupling protrusion 122 of the holder 120 is inserted thereinto. The cover 110 may include the at least one cover protrusion 114 provided to be inserted into the at least one door groove 32d formed in the door accommodation portion 32c.

Referring to FIGS. 6 to 8, the light guide member 130 may include a first portion 132 disposed to face a first surface 141 of the printed circuit board 140 and provided such that light is incident from the at least one light source 150, and a second portion 133 extending from the first portion 132 and provided to reflect light reflected through the first portion 132 to the indicator 131. The first portion 132 may extend along a second direction (Y direction). The first portion 132 may be disposed to be spaced apart from the first surface 141 of the printed circuit board 140 by a predetermined distance in a first direction. The second portion 133 may extend along the first direction (X direction) from one end of the first portion 132. The second portion 133 may extend from an end of the first portion 132 in the second direction toward an inner surface of the cover hole 112.

The second portion 133 of the light guide member 130 may include the indicator 131. The indicator 131 may be provided at a front end (an end in the +X direction) of the second portion 133. The second portion 133 may include a first extension portion 133a and a second extension portion 133b disposed to be spaced apart from each other. The first extension portion 133a and the second extension portion 133b may be spaced apart in the second direction (Y direction). A groove 133c may be formed between the first extension portion 133a and the second extension portion 133b, which are spaced apart from each other. A conductive member 170 may be disposed in the groove 133c formed between the first extension portion 133a and the second extension portion 133b.

The light guide member 130 may include an injection portion 134. The injection portion 134 may be provided to be inserted into an injection hole 121 of the holder 120, which will be described later. According to an embodiment, the injection portion 134 may include a first injection portion 134a and a second injection portion 134b disposed to be spaced apart from each other. The injection portion 134 will be described later.

The light guide member 130 may be formed integrally by injection molding. The first portion 132, the second portion 133, the indicator 131 and the injection portion 134 of the light guide member 130 may be formed integrally by injection molding.

The touch-sensitive device 100 may include the at least one light source 150, the touch sensor 160, the printed circuit board 140 provided such that the at least one light source 150 and the touch sensor 160 are mounted thereon, and the holder 120 configured to support the printed circuit board 140.

The at least one light source 150 may be configured to emit light. For example, the at least one light source 150 may be a light emitting diode (LED). The light emitting diode may be provided to emit light of a wavelength corresponding to at least one of red, green, blue, and white colors.

According to an embodiment, the at least one light source 150 may include a first light source 151, a second light source 152, a third light source 153, and a fourth light source 154 mounted to be spaced apart from each other on the printed circuit board 140. The first light source 151, the second light source 152, the third light source 153, and the fourth light source 154 may be disposed to be spaced apart from each other along a direction in which the indicator 131 extends (Z direction). However, the present disclosure is not limited thereto. The number and arrangement of the light sources 150 may be changed.

According to an embodiment, the at least one light source 150 may be mounted on the first surface 141 of the printed circuit board 140. The touch sensor 160 may be mounted on a second surface 142 of the printed circuit board 140. The first surface 141 of the printed circuit board 140 may be disposed to face the front (+X direction) of the refrigerator 1. The second surface 142 of the printed circuit board 140 may be disposed to face the rear (-X direction) of the refrigerator 1.

The touch sensor 160 may be a touch sensor that is operated by an electrostatic capacitance method. The touch sensor 160 mounted on the second surface 142 of the printed circuit board 140 may be electrically connected to a terminal provided on the first surface 141 of the printed circuit board 140 through a via formed on the printed circuit board 140. A transparent electrode 172 of the conductive member 170, which will be described later, may be electrically connected to a terminal provided on the first surface 141 of the printed circuit board 140. Accordingly, the touch sensor 160 may be electrically connected to the transparent electrode 172.

A thickness of the touch sensor 160 may be thicker than a thickness of the at least one light source 150. The thicknesses of the touch sensor 160 and the at least one light source 150 may be referred to as lengths in the first direction (X direction). In a case where the touch sensor 160 is mounted on the first surface 141 of the printed circuit board 140 on which the at least one light source 150 is disposed, the first portion 132 of the light guide member 130 and the touch sensor 160 may interfere with each other. In order to avoid interference between the first portion 132 and the touch sensor 160, when a distance between the at least one light source 150 and the first portion 132 of the light guide member 130 in the first direction increases, a distance between the indicator 131 and the at least one light source 150 increases, so that the intensity of light emitted through the indicator 131 may be reduced, and the brightness of the indicator 131 may be reduced.

According to an embodiment, because the touch sensor 160 is mounted on the second surface 142 of the printed circuit board 140, the interference between the first portion 132 of the light guide member 130 and the touch sensor 160, which has been described above, may be avoided. Therefore, the brightness reduction of the indicator 131 may be prevented.

The light guide member 130 may be made of a material reflecting light incident from the at least one light source 150 into the inside of the light guide member 130. The light incident on the light guide member 130 may be transmitted to the indicator 131 by being reflected inside the light guide member 130. The light guide member 130 may have a refractive index greater than a refractive index of an external environment such as air. The light guide member 130 may be formed of a translucent resin. The light guide member 130 may be molded by injection molding the translucent resin. For example, the light guide member 130 may be made of a material such as polymethyl methacrylate (PMMA) and polycarbonate (PC), which have high light transmittance and strong durability. For example, the light guide member 130 may be formed of a resin having diffusion properties of 50 percent light transmittance.

Referring to FIGS. 6 to 8, the holder 120 may support the printed circuit board 140. The holder 120 may include a plurality of support protrusions 123 provided to support the second surface 142 of the printed circuit board 140. The plurality of support protrusions 123 may be provided to support a portion of a side surface of the printed circuit board 140 and a portion of the second surface 142 adjacent to the side surface, respectively. As the plurality of support protrusions 123 is disposed to be spaced apart along an edge of the printed circuit board 140, the plurality of support protrusions 123 may stably support the printed circuit board 140.

The holder 120 may be coupled to the cover 110. As described above, the cover 110 may include the coupling hole 113, and the holder 120 may include the coupling protrusion 122 provided to be inserted into the coupling hole 113. The holder 120 is coupled to the cover 110 by insertion of the coupling protrusion 122 into the coupling hole 113.

The holder 120 may be configured to cover at least a portion of the light guide member 130. The holder 120 may prevent light, which is not reflected inside the light guide member 130 and has passed through the light guide member 130, from leaking into a gap between the cover 110 and the door 30. Specifically, the holder 120 may cover a front surface of the first portion 132 of the light guide member 130, and one side surface of at least a portion of the second portion 133. The at least a portion of the 133 of the second portion may refer to the first extension portion 133a.

Referring to FIG. 9, the reason why the holder 120 covers one side surface of the first extension portion 133a and does not cover the second extension portion 133b is because the cover 110 covers the second extension portion 133b. Because the cover 110 is formed of a material that is impermeable to light, even though light passes through the second extension portion 133b covered by the cover 110, the light may not leak out of the cover 110.

As illustrated in FIG. 9, the front surface of the first portion 132 and the side surface of the first extension portion 133a may not be covered by the cover 110. In this case, light passed through the first portion 132 or the first extension portion 133a may proceed toward the inside of the door 30. In a case where the door 30 is formed of a material that is impermeable to light, light proceeded to the inside of the door 30 may be seen from the outside of the door 30. Even though the door 30 is formed of a material that is impermeable to light, a gap exists between the cover 110 and the side surface 32a of the door 30 due to assembly tolerances, and light may leak through this gap. In other words, a light leaking phenomenon may occur. Hereinafter, the light leaking phenomenon and light leakage may be used as the identical meanings.

The holder 120 may prevent light passed through the light guide member 130 from leaking to the door 30 side by covering at least a portion of the light guide member 130. When light leaks through the gap between the cover 110 and the door 30, the effectiveness of identifying the indicator 131 in a dark place may be reduced, and the aesthetic sensibility and completeness of the refrigerator 1 may be degraded.

The holder 120 may be formed of an opaque resin such that light passed through the light guide member 130 does not pass through the holder 120. When light passed through the light guide member 130 also passes through the holder 120, the light leaking phenomenon described above may occur. In order to prevent light leakage through the gap between the cover 110 and the door 30 or the light leaking phenomenon, the holder 120 may be formed of an opaque resin.

The holder 120 may be formed in a white tone color to reflect light incident on an inner surface of the holder 120 toward the light guide member 130. In a case where the holder 120 absorbs most of the light incident on the inner surface of the holder 120, the light transmission efficiency to the indicator 131 may be reduced. When the light transmission efficiency to the indicator 131 is reduced, the brightness of the indicator 131 may be reduced. In order to prevent the brightness of the indicator 131 from being reduced, the holder 120 may be formed to have a white tone color.

The holder 120 may be formed of an opaque resin of a white color in order to prevent the light leaking phenomenon and the brightness reduction of the indicator 131. The holder 120 may be molded by injection molding an opaque resin of a white color.

According to the present disclosure, the holder 120 and the light guide member 130 may be formed integrally. More specifically, the holder 120 and the light guide member 130 may be formed integrally by double injection molding. For example, by first injecting the holder 120 and second injecting the light guide member 130, the holder 120 and the light guide member 130 may be molded integrally.

The holder 120 may include the injection hole 121 provided such that the light guide member 130 may be second injected after the holder 120 is first injected. The holder 120 may be molded by first injection molding an opaque resin of a white color. The light guide member 130 may be molded by secondary injection of a translucent resin through the injection hole 121 after the holder 120 is molded. As the holder 120 and the light guide member 130 are formed integrally by double injection, the holder 120 and the light guide member 130 having different materials may be formed integrally without a separate process such as assembly, bonding, or coupling.

According to an embodiment, the injection hole 121 of the holder 120 may include a first injection hole 121a and a second injection hole 121b for smooth injection molding of the light guide member 130. However, the present disclosure is not limited thereto. The number of the injection holes 121 may be changed.

At least a portion of the light guide member 130 may be exposed to the outside of the holder 120 through the injection hole 121. Specifically, the injection portion 134 of the light guide member 130 may be exposed to the outside of the holder 120 through the injection hole 121. The injection portion 134 may have a size and shape corresponding to the injection hole 121. According to an embodiment, the injection portion 134 may include the first injection portion 134a inserted into the first injection hole 121a to be exposed to the outside of the holder 120, and the second injection portion 134b inserted into the second injection hole 121b to be exposed to the outside of the holder 120. The injection portion 134 may extend in the second direction (+Y direction) from a side end of the first portion 132.

Referring to FIGS. 6, 9 and 10, the touch-sensitive device 100 may include the conductive member 170 disposed between the indicator 131 and the printed circuit board 140.

The conductive member 170 may be provided between an inner surface 131a of the indicator 131 and the first surface 141 of the printed circuit board 140. The inner surface 131a of the indicator 131 may refer to one surface of the indicator 131 or a portion of the light guide member 130 that faces the first surface 141 of the printed circuit board 140 and is disposed on the inner side of the cover 110.

The conductive member 170 may be configured to transmit a touch input of the user to the indicator 131 to the touch sensor 160. The conductive member 170 may serve to transmit the touch input of the user to the indicator 131 to the touch sensor 160 disposed to be spaced apart from the indicator 131. The conductive member 170 may fill a space between the inner surface 131a of the indicator 131 and the first surface 141 of the printed circuit board 140. The conductive member 170 may support the indicator 131 and absorb an impact applied to the indicator 131 by being disposed between the inner surface 131a of the indicator 131 and the first surface 141 of the printed circuit board 140.

The conductive member 170 may be configured to be in contact with the inner surface 131a of the indicator 131 and the first surface 141 of the printed circuit board 140. The conductive member 170 may be electrically connected to a terminal or wiring provided on the first surface 141 of the printed circuit board 140 and electrically connected to the touch sensor 160.

Referring to FIGS. 9 and 10, the conductive member 170 may include a block body 171, and a transparent electrode 172 provided to cover at least a portion of an outer surface of the block body 171. The transparent electrode 172 may include indium tin oxide (ITO). The transparent electrode 172 may have the form of a film or thin foil.

As illustrated in FIGS. 9 and 10, the transparent electrode 172 may cover the front, rear, upper and lower surfaces of the block body 171. The front surface of the block body 171 may point to one surface of the block body 171 facing the +X direction, and the rear surface of the block body 171 may point to one surface of the block body 171 facing the -X direction. The upper surface of the block body 171 may point to one surface of the block body 171 facing the +Z direction, and the lower surface of the block body 171 may point to one surface of the block body 171 facing the -Z direction.

According to an embodiment, the transparent electrode 172 may cover all surfaces of the block body 171, or may cover the front surface, the rear surface, and opposite side surfaces of the block body 171.

The block body 171 may be made of a transparent material such that light incident from the at least one light source 150 to the first portion 132 and/or the second portion 133 of the light guide member 130 may direct to the indicator 131 along the inside of the second portion 133 of the light guide member 130 without being interfered with by the block body 171. For example, the block body 171 may be silicone rubber having a predetermined elasticity and formed to be transparent. The block body 171 may also be formed of transparent glass. The block body 171 may be formed of porous foam having porosity sufficient to allow at least one portion of light emitted from the at least one light source 150 to pass through. The block body 171 may be configured to include at least one of the porous foam, silicone rubber, and glass passing light reflected along the inside of the light guide member 130.

As described above, because it is necessary to dispose the conductive member 170 on an inner side of the indicator 131 to transmit a touch of the user on the indicator 131 to the touch sensor 160, it is difficult to dispose the at least one light source 150 such that the light source faces the inner surface 131a of the indicator 131. The at least one light source 150 may be disposed on one side of the conductive member 170 to avoid interference with the conductive member 170. The at least one light source 150 may be disposed to be spaced apart from the indicator 131 in the first direction (X direction) and the second direction (Y direction). In this arrangement, most of the light emitted from the light source 150 may be incident on the first portion 132 of the light guide member 130.

The light guide member 130 may reflect light inside the light guide member 130 and transmit the reflected light to the indicator 131. Light incident on the first portion 132 of the light guide member 130 may be reflected from the first portion 132 and the second portion 133 to direct to the indicator 131.

As described above, the conductive member 170 may be disposed in the groove 133c of the light guide member 130. Because the conductive member 170 is formed of a material allowing at least one portion of the incident light to pass through, light incident on the conductive member 170 from the light source 150 and at least one of the first portion 132 and the second portion 133 may pass through the conductive member 170 and be reflected from the second portion 133. The light reflected from the second portion 133 may be emitted through the indicator 131.

However, in a case where a part of light incident on the first portion 132 passes through the first portion 132 and directs to the inside of the door 30, or a part of the light incident on the second portion 133 passes through the second portion 133 and directs to the gap between the door 30 and the cover 110, the light leaking phenomenon may occur in the door 30. The light leaking phenomenon may deteriorate the aesthetic sensibility and completeness of the refrigerator 1. In order to prevent this, the holder 120, which is formed integrally with the light guide member 130, may cover at least a portion of the light guide member 130. The holder 120 may be formed of a material that is not transparent to light. Through this, light may not leak in at least a portion of the light guide member 130 covered by the holder 120. As the holder 120 covers the light guide member 130, unintended light leakage may be prevented, and light may be emitted only from the indicator 131. As light is emitted only from the indicator 131, the user may more easily identify the indicator 131, and the aesthetic sensibility and completeness of the refrigerator 1 may be improved.

According to an embodiment, a refrigerator includes a main body having a storage compartment, a door configured to open and close the storage compartment, a door opening device configured to open the door, and a touch-sensitive device configured to detect a touch for operating the door opening device. The touch-sensitive device includes a cover disposed on the door, an indicator exposed to the outside of the cover and configured to emit light, at least one light source disposed on an inner side of the cover, a printed circuit board on which the at least one light source is mounted, a light guide member configured to transmit light emitted from the at least one light source to the indicator, and a holder configured to cover the at least a portion of the light guide member to prevent light from leaking to a gap between the cover and the door and to support the printed circuit board.

A first surface of the printed circuit board on which the at least one light source is mounted may be disposed to face a first direction.

The at least one light source may be spaced apart from the indicator on the inner side of the cover in the first direction and a second direction perpendicular to the first direction.

The light guide member may include a first portion extending along the first direction and a second portion extending along the second direction.

The second portion may include the indicator.

The holder may be configured to cover at least a portion of the first portion and the second portion of the light guide member between the door and the light guide member.

The light guide member may further include an injection portion extending in the second direction from one end of the second portion.

The holder may include an injection hole into which the injection portion is inserted and which exposes the injection portion to the outside of the holder.

The holder and the light guide member may be formed integrally. For example, by first injecting the holder and second injecting the light guide member through the injection hole, the holder and the light guide member may be formed integrally.

The touch-sensitive device may further include a touch sensor mounted on the printed circuit board, and a conductive member provided between the indicator and the printed circuit board to electrically connect the indicator and the touch sensor.

The conductive member may include a block body having a first end disposed adjacent to an inner surface of the indicator and a second end disposed adjacent to the printed circuit board, and extending in the first direction from the first end toward the second end.

The conductive member may include a transparent electrode provided on an outer surface of the block body to be electrically connected to the touch sensor.

The at least one light source may be disposed to be spaced apart from the second end of the block body in the second direction.

The light guide member may be configured to reflect one portion of light incident on the light guide member and pass the other portion.

The holder may be configured to block one portion of light incident on the holder and reflect the other portion.

The light guide member may be configured by including a translucent resin. For example, the light guide member may be made of translucent resin.

The holder may be configured by including an opaque resin of a white color. For example, the holder may be made of an opaque resin of a white color.

The block body may include at least one of porous foam, silicone rubber, and glass through which light reflected along the inside of the light guide member passes.

The holder may include a plurality of support protrusions provided to support a second surface opposite to the first surface of the printed circuit board.

The holder may further include a coupling protrusion provided to be inserted into a coupling hole formed on the cover.

The holder may be coupled to the cover by insertion of the coupling protrusion into the coupling hole.

The cover may include a cover hole corresponding to a shape and size of the indicator.

The indicator may be a portion of the light guide member provided to be inserted into the cover hole.

According to the present disclosure, a refrigerator comprising a touch-sensitive device including an indicator provided to emit light and a door opening device configured to operate based on a touch to the indicator can be provided.

According to the present disclosure, a touch-sensitive device including a light guide member configured to transmit light emitted from a light source to an indicator and a holder configured to cover at least a portion of the light guide member to prevent light passed through the light guide member from leaking, and a refrigerator including the same can be provided.

According to the present disclosure, a touch-sensitive device in which a light guide member including an indicator and a holder configured to cover the light guide member to prevent light leakage are formed integrally to reduce production costs, and a refrigerator including the same can be provided.

The foregoing has illustrated and described specific embodiments. However, the present disclosure is not limited to the above-described embodiments, and various modifications may be made by a person skilled in the art to which the invention belongs without departing from the gist of the technical idea of the invention described in the claims below.

## Claims

1. A refrigerator comprising:
a main body having a storage compartment;
a door configured to open and close the storage compartment;
a door opening device configured to open the door; and
a touch-sensitive device configured to detect a touch for operating the door opening device,
wherein the touch-sensitive device includes
a cover disposed on the door,
an indicator exposed to the outside of the cover and configured to emit light,
at least one light source disposed on an inner side of the cover,
a printed circuit board on which the at least one light source is mounted,
a light guide member configured to transmit light emitted from the at least one light source to the indicator, and
a holder configured to cover the at least a portion of the light guide member to prevent light from leaking to a gap between the cover and the door and to support the printed circuit board.

2. The refrigerator according to claim 1, wherein
a first surface of the printed circuit board on which the at least one light source is mounted is disposed to face a first direction, and
the at least one light source is spaced apart from the indicator on the inner side of the cover in the first direction and in a second direction perpendicular to the first direction.

3. The refrigerator according to claim 2, wherein
the light guide member includes a first portion extending along the first direction and a second portion extending along the second direction, and
the second portion includes the indicator.

4. The refrigerator according to claim 3, wherein
the holder is configured to cover at least a portion of the first portion and the second portion of the light guide member between the door and the light guide member.

5. The refrigerator according to claim 3, wherein
the light guide member further includes an injection portion extending in the second direction from one end of the second portion, and
the holder includes an injection hole into which the injection portion is inserted and which exposes the injection portion to the outside of the holder.

6. The refrigerator according to claim 5, wherein
by first injecting the holder and second injecting the light guide member through the injection hole, the holder and the light guide member are formed integrally.

7. The refrigerator according to claim 2, wherein
the touch-sensitive device further includes
a touch sensor mounted on the printed circuit board, and
a conductive member provided between the indicator and the printed circuit board to electrically connect the indicator and the touch sensor.

8. The refrigerator according to claim 7, wherein
the conductive member includes
a block body having a first end disposed adjacent to an inner surface of the indicator and a second end disposed adjacent to the printed circuit board, and extending in the first direction from the first end toward the second end, and
a transparent electrode provided on an outer surface of the block body to be electrically connected to the touch sensor.

9. The refrigerator according to claim 8, wherein
the at least one light source is disposed to be spaced apart from the second end of the block body in the second direction.

10. The refrigerator according to claim 1, wherein
the light guide member is configured to reflect one portion of light incident on the light guide member and pass the other portion, and
the holder is configured to block one portion of light incident on the holder and reflect the other portion.

11. The refrigerator according to claim 10, wherein
the light guide member is configured by including a translucent resin, and
the holder is configured by including an opaque resin of a white color.

12. The refrigerator according to claim 8, wherein
the block body includes at least one of porous foam, silicone rubber, and glass through which light reflected along the inside of the light guide member passes.

13. The refrigerator according to claim 2, wherein
the holder includes a plurality of support protrusions provided to support a second surface opposite to the first surface of the printed circuit board.

14. The refrigerator according to claim 1, wherein
the holder further includes a coupling protrusion provided to be inserted into a coupling hole formed on the cover, and
wherein the holder is coupled to the cover by insertion of the coupling protrusion into the coupling hole.

15. The refrigerator according to claim 1, wherein
the cover includes a cover hole corresponding to a shape and size of the indicator, and
the indicator is a portion of the light guide member provided to be inserted into the cover hole.
